# FASCICULE DE BREVET EUROPEEN

(11) **EP 2 777 070 B1**
(45) Date de publication et mention de la délivrance du brevet: **20.07.2016**
(21) Numéro de dépôt: 12801637.5
(22) Date de dépôt: 31.10.2012
(51) Int. Cl.: H01L 21/683, H01L 21/02

(54) **PROCÉDÉ D'OBTENTION D'UN SUBSTRAT HÉTÉROGÈNE POUR LA FABRICATION DE SEMI-CONDUCTEUR ET SUBSTRAT CORRESPONDANT.**
VERFAHREN ZUR HERSTELLUNG EINES HETEROGENEN SUBSTRATS FÜR DIE HERSTELLUNG VON HALBLEITERN UND ENTSPRECHENDES SUBSTRAT
METHOD FOR OBTAINING A HETEROGENEOUS SUBSTRATE FOR THE PRODUCTION OF SEMICONDUCTORS, AND CORRESPONDING SUBSTRATE

(30) Priorité: 09.11.2011 FR 1160193
(43) Date de publication de la demande: 17.09.2014
(73) Titulaire: Commissariat à l'Énergie Atomique et aux Énergies Alternatives, 75015 Paris (FR)
(72) Inventeur: AIT-MANI, Abdenacer, F-38120 Saint Egreve (FR); HUET, Stéphanie, F-45630 Beaulieu sur Loire (FR)
(74) Mandataire: Gevers & Orès
(86) Numéro de dépôt international: PCT/IB2012/056061
(87) Numéro de publication internationale: WO 2013/068891

(56) Documents cités:
- EP-A1- 2 339 617
- WO-A1-2005/083774
- US-B1- 6 248 646

## Description

L'invention concerne le domaine de la microélectronique.

Elle porte sur un procédé permettant de réaliser un substrat en matériau semi-conducteur de dimensions compatibles avec les standards de la microélectronique, à partir d'un substrat ne correspondant pas à ces standards.

Dans la fabrication microélectronique, différents substrats peuvent être utilisés selon les applications. Ils présentent des dimensions et des géométries différentes et peuvent également être réalisés dans des matériaux différents.

Ainsi, sont disponibles des substrats de silicium en forme de disque, dont le diamètre peut être de 100, 150, 200 ou encore 300 mm.

Par ailleurs, les équipements technologiques sont spécifiquement adaptés à des dimensions particulières du substrat.

Ces équipements seront notamment conçus pour des opérations de dépôt, de gravure, de nettoyage ou encore de métrologie.

Différentes filières intégrant des équipements spécifiques doivent être ainsi disponibles pour pouvoir traiter des substrats de silicium de tailles différentes.

Cependant, il existe d'autres types de substrats, notamment ceux destinés à l'industrie photovoltaïque. Ces substrats sont généralement de forme carrée ou ronde et présentent des dimensions inférieures à celles des substrats en silicium.

Ainsi, par exemple, les substrats en matériau de type II-VI, comme CdTe ou CdHgTe, se présentent sous la forme de plaques sensiblement carrées dont les dimensions sont typiquement de 36x38 mm ou 47x48 mm. Par ailleurs, les substrats en matériau de type III-V, comme InSb, InP, InAs ou GaAs, se présentent sous forme de plaques dont le diamètre est typiquement de 2 ou 3 pouces ou encore 100 mm.

Ces substrats ne peuvent pas être traités facilement sur un équipement technologique conçu pour un substrat de silicium de dimensions supérieures.

C'est pourquoi, ont été développés des procédés permettant d'obtenir un substrat de diamètre plus important, à partir d'un substrat de dimensions faibles.

Ainsi, le document EP-2 339 617 décrit un procédé consistant à utiliser un premier substrat dans lequel est réalisé un trou traversant dont la surface est plus importante que celle d'un deuxième substrat dont les dimensions sont insuffisantes pour pouvoir être traité par les équipements disponibles.

Lors de la mise en oeuvre du procédé, les deux substrats sont temporairement fixés à un premier support. Le deuxième substrat est placé dans le premier substrat et l'espace laissé libre entre les deux substrats est rempli par un matériau. L'ensemble est ensuite fixé à un deuxième support, avant le retrait du premier support, de telle sorte que la zone active du deuxième substrat est apparente.

Ce procédé présente l'inconvénient d'être relativement complexe, notamment du fait de l'utilisation de deux supports différents.

Par ailleurs, le trou traversant est formé dans le premier substrat par découpage circulaire. Ceci peut notamment être effectué avec une lame diamantée. Or, ce découpage produit classiquement des éclats sur le substrat. Ces éclats sont encore plus présents pour des substrats d'épaisseur importante ou pour des substrats réalisés dans des matériaux durs.

Ceci fragilise le substrat, peut causer des clivages et rendre le substrat inutilisable.

L'invention a pour objet de pallier ces inconvénients en proposant un procédé d'obtention d'un substrat hétérogène destiné à être utilisé lors de la fabrication d'un semi-conducteur qui est d'une mise en oeuvre simplifiée et qui limite les risques de détérioration du substrat.

Un autre document, US 6 248 646 B1, décrit l'intégration de petits substrats de faible épaisseur dans un substrat plus large.

Selon l'invention, le procédé de l'invention comprend les étapes suivantes :
(a) la fourniture d'un premier substrat en un matériau du type II-VI ou III-V et d'un deuxième substrat sensiblement plans et présentant chacun une surface déterminée,
(b) la réalisation par meulage dans le deuxième substrat d'un évidement non traversant, la surface de cet évidement étant supérieure à la surface du premier substrat, de telle sorte que le premier substrat peut être logé dans ledit évidement,
(c) le dépôt d'un matériau de collage dans ledit évidement,
(d) le dépôt du premier substrat dans l'évidement du deuxième substrat et sa fixation dans le deuxième substrat, à une température inférieure à 300°C,
(e) une mise à niveau des premier et deuxième substrats pour obtenir un substrat hétérogène présentant une face sensiblement plane.

De façon préférée, un polissage de l'évidement est réalisé entre les étapes (b) et (c).

Ce polissage permet de retrouver l'état de surface d'origine du matériau constitutif du substrat, après la réalisation de l'évidement.

Par ailleurs, entre les étapes (b) et (c), une texturation peut être réalisée dans le fond de l'évidement.

De façon préférée, le deuxième substrat est réalisé dans un matériau dont le module d'Young est supérieur à 50 GPa.

En effet, l'utilisation d'un substrat relativement rigide et présentant une résistance mécanique plus élevée, permet de limiter l'apparition de défauts lors de la réalisation de l'évidement, ces défauts pouvant générer des éclats ou des clivages et fragiliser le substrat.

Egalement de façon préférée, la différence entre le coefficient d'expansion thermique du premier substrat et celui du deuxième substrat est inférieure à 28% dans la gamme de température allant de 0 à 300°C.

En effet, le fait de limiter la différence entre les coefficients d'expansion thermique des deux substrats permet de limiter le risque de détérioration de l'assemblage des deux substrats, dû à la dilatation thermique.

L'étape (e) est avantageusement réalisée par meulage.

Le procédé peut également consister à déposer une couche de passivation sur les deux substrats, après l'étape (e).

Il peut également comporter une dernière étape consistant en un amincissement des deux substrats.

Enfin, l'invention concerne un substrat hétérogène destiné à être utilisé lors de la fabrication d'un semi-conducteur, comprenant :
- un premier substrat sensiblement plan présentant une surface déterminée et en un matériau du type II-VI ou III-V,
- un deuxième substrat sensiblement plan et présentant un évidement non traversant, la surface de cet évidement étant supérieure à la surface du premier substrat,
le premier substrat étant disposé dans le deuxième substrat, un espace est ménagé entre les deux substrats qui est rempli d'un matériau de collage et la face sur laquelle affleurent les deux substrats étant sensiblement plane.

De façon préférée, cette face est recouverte d'une couche de passivation.

L'invention sera mieux comprise et d'autres buts, avantages et caractéristiques de celle-ci apparaîtront plus clairement à la lecture de la description qui suit et qui est faite au regard des dessins annexés sur lesquels :
- la figure 1 est une vue en coupe d'un substrat dans lequel un évidement est en cours de réalisation,
- la figure 2 est une vue en coupe d'un substrat présentant un évidement et dont le fond a été rainuré,
- la figure 3 représente le substrat illustré à la figure 2, de la colle étant déposée dans le fond de l'évidement,
- la figure 4 est une vue en coupe du substrat illustré à la figure 3, dans l'évidement duquel un autre substrat a été mis en place,
- la figure 5 est une vue similaire à la figure 4 qui représente les deux substrats après leur mise à niveau,
- la figure 6 est une vue similaire à la figure 5 qui représente une couche de passivation sur l'assemblage des deux substrats et
- la figure 7 montre l'assemblage illustré à la figure 6, après amincissement du substrat.

Les éléments communs aux différentes figures seront illustrés par les mêmes références.

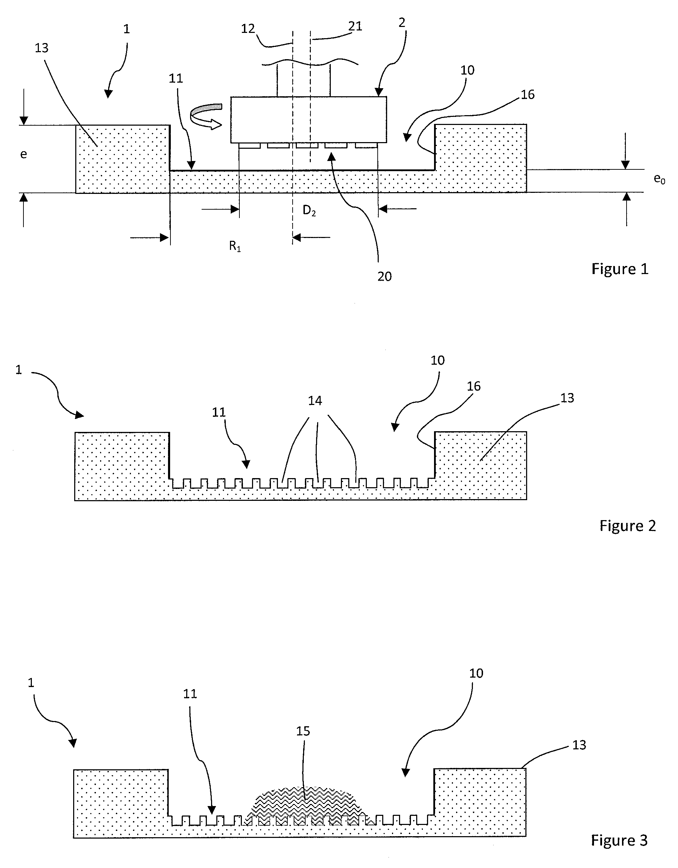

La figure 1 illustre une étape du procédé selon l'invention, dans laquelle un substrat 1 est usiné au moyen d'un dispositif de meulage 2.

Le substrat 1 est sensiblement plan et présente, au début de cette étape d'usinage, une épaisseur e sensiblement constante.

Le substrat 1 est, de préférence, réalisé en un matériau présentant un module d'Young supérieur à 50 GPa. Les risques de formation de copeaux d'usinage sont ainsi limités. Ceci limite également les risques d'apparition de rayures et d'obtention d'une surface non polie, ainsi que les risques de fragilisation de la surface du substrat.

Les matériaux constitutifs du substrat 1 peuvent être notamment : le silicium, le germanium, le saphir, le verre borosilicate ou encore la plupart des céramiques, telles que le verre céramique, l'alumine, le carbure de silicium ou le nitrure d'aluminium.

Le substrat 1 peut notamment se présenter sous la forme d'un disque dont le diamètre peut, par exemple, être de 150, 200 ou 300 mm et dont l'épaisseur est comprise entre 725 µm et 1 mm.

Dans le substrat 1, est réalisé un évidement 10 non traversant au moyen de l'outil de meulage 2, ce qui limite les risques de fragilisation du substrat.

C'est pourquoi, ce substrat présente, de préférence, une planéité de surface conforme aux normes en vigueur dans la microélectronique (Normes SEMI). En effet, l'outil de meulage peut ainsi être parallèle à la surface du substrat, ce qui limite le stress engendré par le meulage. Lorsque la planéité de surface n'est pas assurée, l'outil de meulage présente un angle non nul par rapport à la surface du substrat, ce qui entraîne un stress de contact important sur une étendue faible.

L'épaisseur e₀ du substrat, au niveau du fond 11 de l'évidement, doit être suffisamment importante pour ne pas fragiliser le substrat.

De façon générale, on peut considérer que l'épaisseur e₀ doit être supérieure à 200 µm. Ainsi, un évidement présentant une profondeur de 725 µm pourra être réalisé dans un substrat de 1 mm d'épaisseur, tandis qu'un évidement présentant une profondeur de 500 µm pourra être réalisé dans un substrat de 725 µm d'épaisseur.

L'évidement 10 peut notamment être réalisé en mettant en oeuvre le procédé décrit dans le document US-7 705 430. Ce procédé diffère des techniques classiques de meulage en ce qu'il ne procède au meulage que dans une circonférence intérieure du substrat et laisse donc un bord sur la circonférence extérieure du substrat.

La présence de ce bord extérieur sur le substrat permet notamment de diminuer les risques de déformation du substrat et améliore sa résistance.

En pratique, ce procédé consiste à utiliser un outil de meulage 2 dans lequel le diamètre extérieur D2 de la partie active 20 de l'outil est plus important que le rayon R1 de l'évidement 10 à former.

L'outil de meulage 2 est positionné par rapport au substrat 1 de telle sorte que le bord périphérique extérieur de la partie active 20 est inscrit à l'intérieur de la limite périphérique de l'évidement 10 à former. Par ailleurs, la partie active 20 de l'outil 2 est placée à cheval sur l'axe central 12 du substrat 1 et l'outil 2 est entraîné en rotation autour de son axe central 21.

Lorsque l'outil 2 est entraîné en rotation, il est également graduellement déplacé vers le bas de façon à s'enfoncer dans le substrat 1. Ce dernier est monté sur un porte-outil qui est lui-même entraîné en rotation.

Ainsi, ce procédé permet de former l'évidement 10, tout en maintenant, en périphérie du substrat 1, un bord annulaire extérieur 13 dont l'épaisseur correspond à l'épaisseur initiale e du substrat.

La paroi interne 16 du bord 13 est sensiblement verticale par rapport au fond 11 de l'évidement.

Contrairement aux procédés classiques de meulage, ce procédé ne nécessite pas de fixer au préalable le substrat sur un support en matériau rigide, tel que du verre. Au contraire, la fixation du substrat s'effectue directement sur le porte-outil. Ceci permet de simplifier la mise en oeuvre du procédé et constitue donc un avantage par rapport aux procédés classiques.

Par ailleurs, en utilisant un outil de meulage adapté, ce procédé permet d'obtenir sur la surface de l'évidement 10, une finition lissée. Ce type de finition est garante d'un minimum de défauts sur la surface de l'évidement.

Cependant, un substrat en matériau dur est toujours meulé en 2 ou 3 étapes, les premières étapes étant mises en oeuvre avec des meules à gros grains.

On peut noter que l'absence d'éclats est favorisée par l'enlèvement de matière en couches fines successives et le mouvement relatif de la meule et du substrat.

Cette étape de meulage est réalisée à température ambiante. Cependant, il n'existe pas à ce stade de contrainte sur le niveau de la température.

De façon générale, cette étape limite les contraintes mécaniques générées dans le substrat 1.

Une fois que l'évidement 10 est réalisé, une autre étape peut être mise en oeuvre pour éliminer le stress mécanique résultant des premières étapes de meulage.

En effet, après avoir été meulé, un matériau perd son état de surface d'origine sur une épaisseur de quelques microns. Ceci est notamment le cas pour un matériau monocristallin. Ainsi, par exemple pour le silicium, le réseau cristallin est détérioré ou écroui sur une profondeur comprise entre 1 et 2 µm.

Cet écrouissage sur la surface de l'évidement 10 est susceptible de déformer le substrat, du fait de discontinuités dans le réseau cristallin susceptibles de générer des contraintes.

Cette étape complémentaire consiste à effectuer un polissage de la surface intérieure de l'évidement 10. Grâce à cette étape, la surface intérieure de l'évidement retrouve l'arrangement atomique ou cristallin existant à l'origine sur le substrat 1. Ceci permet de garantir la stabilité mécanique du substrat lors des recuits en température.

Le procédé peut également consister à réaliser successivement et en alternance plusieurs étapes de meulage et de polissage. On obtient alors un relâchement progressif des contraintes.

La réalisation de l'évidement 10 peut mettre en oeuvre une gravure chimique humide si le substrat est monocristallin.

Elle permet d'obtenir des surfaces très lisses. Cependant, le temps nécessaire à la gravure est long lorsque l'épaisseur du substrat qui doit être retirée est supérieure à plusieurs centaines de microns.

Lorsque le substrat est en silicium, l'évidement peut être réalisé par une technique d'usinage, à base de plasmas fluorés. Cette technique alterne des étapes de gravure avec du SF₆ et de passivation, mettant en oeuvre par exemple du C₄F₈.

Elle permet de graver en profondeur le silicium mais elle crée des bords arrondis.

La figure 2 illustre une autre étape du procédé selon l'invention, dans laquelle sont réalisées des rainures 14 dans le fond 11 de l'évidement 10 pour former une texturation.

Les rainures illustrées sur la figure 2 sont régulières et sont par exemple réparties selon deux séries de lignes parallèles qui se croisent à angle droit. Ceci permet une répartition annulaire de la contrainte et évite les risques de clivage de la structure.

Les rainures peuvent notamment être réalisées au moyen d'un laser. Par ailleurs, elles peuvent présenter une largeur et une hauteur comprises entre quelques µm et 50 µm, et être typiquement de l'ordre de 25 µm.

A la place des rainures 14, le procédé peut consister à réaliser, par gravure chimique, une texturation aléatoire sur le fond 11 de l'évidement 10.

Cependant, l'obtention d'une texturation aléatoire est plus difficile à obtenir que des rainures. En particulier, il s'avère plus difficile d'obtenir une rugosité de l'ordre de quelques µm par gravure chimique que par l'utilisation d'un laser.

Il convient de noter que, grâce au polissage de l'évidement, la texturation est réalisée sur une couche stable.

L'intérêt d'une texturation régulière ou aléatoire sera expliqué dans la suite de la description.

La figure 3 illustre une étape suivante du procédé, dans laquelle une goutte calibrée d'un matériau de collage est déposée dans le fond 11 de l'évidement 10.

Le matériau de collage peut notamment consister en une résine époxy, en un polyimide, en un adhésif benzocyclobutène ou encore en un matériau commercialisé par la société Brewer Science sous la dénomination WaferBOND HT-10.10.

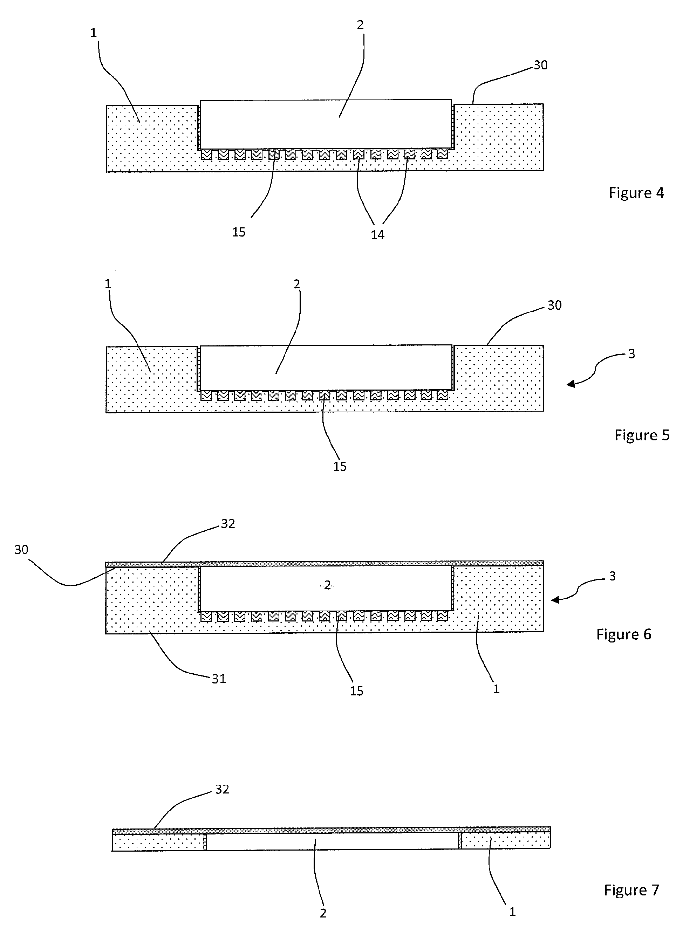

Ce matériau de collage est destiné à assurer la fixation d'un autre substrat dans le substrat 1, comme cela sera décrit en référence à la figure 4.

Ainsi, le volume de colle déposé dans l'évidement 10 est calculé au préalable à partir de l'intervalle à remplir entre les deux substrats et de l'épaisseur du joint souhaitée.

Grâce à un doseur volumétrique, seul le volume de colle nécessaire est déposé dans l'évidement. Ceci permet de limiter la quantité de colle qui pourrait sortir du substrat 1, après l'introduction de l'autre substrat dans l'évidement 10.

On peut encore noter que le matériau de collage présente avantageusement une viscosité suffisamment faible pour pouvoir s'étaler sur la surface interne de l'évidement 10 à température ambiante. Par ailleurs, de façon préférée, il ne contient pas de charges. En effet, celles-ci peuvent générer des défauts de collage.

De façon préférée, avant le dépôt de la goutte de colle 15, la surface interne du logement 10 peut être traitée par un traitement plasma/oxygène. Ce traitement permet, en effet, d'améliorer le mouillage du matériau de collage et de limiter la création de bulles qui pourraient entraîner des défauts de collage.

A cet égard, il convient de noter que la texturation du fond de l'évidement par procédé laser ou chimique, telle qu'illustrée à la figure 2, permet d'augmenter la surface de contact entre le matériau de collage et le substrat 1 et donc d'augmenter la surface totale de collage entre les deux substrats, ce qui rend le collage plus fiable.

La figure 4 illustre une étape suivante du procédé, dans laquelle un substrat 2 est inséré dans le logement 10 du substrat 1.

Ce substrat 2 est sensiblement plan et présente une surface qui est inférieure à la surface de l'évidement 10.

Le substrat 2 peut présenter une forme quelconque, dans la mesure où elle peut être insérée dans un évidement circulaire.

Ce substrat est typiquement réalisé dans un matériau du type II-VI ou III-V, destiné à la détection infrarouge.

A titre d'exemple, pour un substrat 2 réalisé dans un matériau du type CdTe présentant des dimensions de 36x38 mm, le substrat 1 présentera un évidement de diamètre supérieur à 54 mm.

Il est préférable de minimiser l'espacement entre les deux substrats.

A titre d'exemple, cet espacement est inférieur ou égal à 100 µm lorsque le substrat 2 présente la forme d'un disque.

La mise en place du substrat 2 dans le substrat 1 peut notamment être réalisée par un banc spécifique d'assemblage permettant de garantir le centrage d'un substrat par rapport à l'autre. Les deux substrats apparaissent à la surface de la face 30 de l'assemblage obtenu.

On peut notamment citer les équipements communément dénommés « *wafer bonders »* commercialisés sous la dénomination EVG par la société EVGroup ou encore l'équipement commercialisé sous la dénomination SB8 ou CB8 par la société SÜSS MicroTec AG.

Une fois que le substrat 2 est en place dans l'évidement 10, on procède à sa fixation dans l'évidement grâce au matériau de collage. Ceci peut notamment être obtenu par une réticulation du matériau de collage.

Avant l'étape de réticulation, on réalise avantageusement un ou deux points de pression sur le substrat 2 pour initier une onde de collage.

Avec une colle époxy, l'étape de réticulation s'effectue à une température de 150°C pendant 1 heure. Avec une colle polyamide, elle est réalisée à une température comprise entre 280 et 300°C pendant 30 à 60 mn.

Dans la mesure où les matériaux du type II-VI ou III-V présentent une température de fusion comprise entre 300 et 600°C, il est nécessaire que l'étape de collage soit réalisée à une température inférieure à 300°C.

L'observation de ce seuil de température permet également, lorsque le substrat 2 comporte des photodiodes, d'éviter la diffusion d'espèces dopantes présentes dans les photodiodes.

On peut noter que la présence d'une texturation dans le fond de l'évidement permet aux éventuelles bulles d'air de s'échapper, lors de l'étape de réticulation du matériau de collage. Ceci permet également d'améliorer la fixation entre les deux substrats.

De préférence, le matériau constitutif de chacun des substrats 1 et 2 est choisi de telle sorte que leurs coefficients d'expansion thermique soit relativement proches.

En pratique, la différence entre les deux coefficients d'expansion thermique est de préférence inférieure à 28% dans la gamme de températures comprise entre 0 et 300°C.

Cette condition permet de limiter les risques de détérioration de l'assemblage formé par les deux substrats.

Lorsque la différence entre les coefficients d'expansion thermique des deux substrats est trop importante, lors d'une montée en température, cette différence peut conduire au clivage du substrat le moins rigide. En effet, c'est le substrat le plus rigide qui impose son déplacement et l'assemblage s'incurve (effet bilame). Ainsi, un déplacement relatif trop important entre les deux substrats peut conduire à une détérioration de l'assemblage.

De façon générale, les coefficients d'expansion thermique des deux substrats évoluent différemment avec la température. Or, l'assemblage des deux substrats peut être soumis à des montées en température. Ceci peut être dû au mode de fixation des deux substrats (collage à chaud par exemple) ou aux opérations technologiques pouvant être réalisées sur l'assemblage (dépôt ou recuit d'adhérence par exemple).

Lorsque les coefficients d'expansion thermique des deux substrats sont relativement proches, la contrainte qu'un substrat peut exercer sur l'autre est limitée, en cas de montée en température.

A titre d'exemple, deux assemblages ont été réalisés. Dans les deux cas, le substrat 2 a été réalisé en antimoniure d'indium (InSb). Dans le premier assemblage, le substrat 2 en InSb est placé dans un substrat 1 en germanium (Ge), tandis que dans le deuxième assemblage, il est placé dans un substrat 1 en silicium (Si). Dans les deux assemblages, le substrat 1 présente un diamètre de 200 mm et le substrat 2, un diamètre de 100 mm.

Dans le premier assemblage, la différence entre les deux coefficients d'expansion thermique des substrats est inférieure à 0,8 ppm/°K, tandis que dans le deuxième assemblage, elle est supérieure à 2 ppm/°K. Ces valeurs sont données dans la gamme des températures comprises entre la température ambiante et 300°C.

Ces deux assemblages sont soumis à une montée en température depuis la température ambiante jusqu'à 200°C.

On constate alors que le premier assemblage est soumis à une déformation relativement faible, avec une flèche de 3 µm, tandis que le deuxième assemblage est soumis à une forte déformation, avec une flèche de 980 µm (courbure mesurée au centre du substrat).

Ainsi, une différence réduite entre les deux coefficients d'expansion thermique limite le risque de contraintes d'un substrat sur l'autre, lors d'une montée en température imposée notamment par le mode d'assemblage.

Cependant, même si les coefficients d'expansion thermique des substrats sont relativement proches, ils vont évoluer différemment avec la température.

Lorsque le coefficient d'expansion thermique du matériau de collage est choisi de façon à être supérieur au coefficient d'expansion thermique des deux substrats, c'est le matériau de collage qui va absorber les contraintes qui en résultent. Ainsi, lorsque le coefficient d'expansion du matériau de collage est 10 fois supérieur à celui des substrats 1 et 2, le matériau de collage produit un effet tampon qui empêche le transfert des contraintes d'un substrat vers l'autre. En effet, les déplacements entre les deux substrats dus à la montée en température sont ramenés à des petits déplacements du substrat 2 à l'intérieur de l'évidement 10.

Ainsi, dans ce cas, le matériau de collage assure une plage de flexibilité importante.

La figure 5 illustre une étape suivante du procédé dans laquelle, une fois l'assemblage des deux substrats réalisé, les deux substrats sont mis à niveau. La figure 5 montre l'assemblage 3 après cette mise à niveau. La face 30 de l'assemblage, à la surface de laquelle apparaissent les deux substrats, est alors sensiblement plane. Ainsi, aucun espace n'est présent entre les deux substrats, grâce à la présence de la colle.

Le procédé selon l'invention permet donc de constituer un substrat hétérogène qui peut notamment subir une étape de lithographie sur la face 30.

Il convient de noter que ceci n'est pas possible lorsque l'espace latéral entre les deux substrats est important et que les substrats assemblés ne définissent pas une surface plane.

Cette étape de mise à niveau peut notamment être obtenue par une opération de meulage.

Cette opération peut être effectuée même si les deux substrats présentent des coefficients d'expansion thermique relativement éloignés. En effet, le matériau le plus dur impose alors ses paramètres à l'autre matériau.

On notera cependant que, si la différence entre les coefficients d'expansion thermique des deux substrats est faible, l'effet bilame est faible. De ce fait, l'assemblage ne peut présenter qu'un bombé lui-même assez faible. Ainsi, lors du meulage, la quantité de matière à retirer est également plus faible.

Lorsque l'espacement latéral entre les deux substrats est minimisé, on évite la formation d'une cuvette dans la colle qui remplit cet espacement, lors de l'étape de meulage.

Enfin, après cette étape de mise à niveau mécanique des deux substrats, peut également être réalisée une étape de polissage du type CMP (planarisation mécano-chimique) ou à sec à base de feutres à granulométrie ultra-fine.

Cette dernière étape permet d'obtenir un meilleur état de surface sur la face 30 de l'assemblage.

La figure 6 illustre une autre étape du procédé dans laquelle une couche de passivation 32 est déposée sur la face 30 de l'assemblage 3 illustré à la figure 5.

Cette couche de passivation est réalisée en un oxyde isolant tel que de SiO, SiO₂ ou Si₃N₄. L'oxyde choisi doit être compatible avec la filière technologique considérée.

Elle a pour fonction de protéger la face 30.

De plus, grâce à elle, un seul type de matériau apparaît sur la face 30. Ceci est nécessaire pour les étapes de photolithographie, de gravure ou de dépôt ultérieures.

Enfin, cette couche d'oxyde permet de stabiliser l'assemblage 3 en le protégeant d'éventuels contaminants extérieurs.

L'assemblage ainsi obtenu peut être traité par des équipements technologiques adaptés aux dimensions du substrat 1 et donc à des dimensions supérieures à celles du substrat 2. Cet assemblage peut donc être traité et manipulé sans problème par des équipements qui ne sont pas conçus pour le substrat 2.

La figure 7 illustre une dernière étape du procédé, dans laquelle l'assemblage 3 est aminci du côté opposé à la couche de passivation 32.

Le produit obtenu pourra ensuite être découpé pour obtenir des puces unitaires.

Ainsi, le procédé selon l'invention permet de reconstituer un substrat présentant des dimensions compatibles avec les standards de la microélectronique, à partir d'un assemblage hétérogène, tant en ce qui concerne les matériaux constitutifs de l'assemblage que les dimensions des éléments composant cet assemblage.

Les signes de référence insérés après les caractéristiques techniques figurant dans les revendications ont pour seul but de faciliter la compréhension de ces dernières et ne sauraient en limiter la portée.

## Revendications

1. Procédé d'obtention d'un substrat hétérogène destiné à être utilisé lors de la fabrication d'un semi-conducteur, comprenant les étapes suivantes :
(a) la fourniture d'un premier substrat (2) en un matériau du type II-VI ou III-V et d'un deuxième substrat (1) sensiblement plans et présentant chacun une surface déterminée,
(b) la réalisation par meulage dans le deuxième substrat (1) d'un évidement (10) non traversant, la surface de cet évidement étant supérieure à la surface du premier substrat, de telle sorte que le premier substrat peut être logé dans ledit évidement,
(c) le dépôt d'un matériau de collage (15) dans ledit évidement (10),
(d) le dépôt du premier substrat (2) dans l'évidement (10) du deuxième substrat et sa fixation dans le deuxième substrat, à une température inférieure à 300°C,
(e) une mise à niveau des premier et deuxième substrats pour obtenir un substrat hétérogène présentant une face (30) sensiblement plane.

2. Procédé selon la revendication 1, dans lequel un polissage de l'évidement (10) est réalisé entre les étapes (b) et (c).

3. Procédé selon la revendication 1 ou 2, dans lequel, entre les étapes (b) et (c), une texturation (14) est réalisée dans le fond de l'évidement (10).

4. Procédé selon l'une des revendications 1 à 3, dans lequel le deuxième substrat (1) est réalisé dans un matériau dont le module d'Young est supérieur à 50 GPa.

5. Procédé selon l'une des revendications 1 à 4, dans lequel la différence entre le coefficient d'expansion thermique du premier substrat et celui du deuxième substrat est inférieure à 28% dans la gamme de température allant de 0 à 300°C.

6. Procédé selon l'une des revendications 1 à 5, dans lequel l'étape (e) est réalisée par meulage.

7. Procédé selon l'une des revendications 1 à 6, dans lequel une couche de passivation (32) est déposée sur les deux substrats, après l'étape (e).

8. Procédé selon la revendication 7, dans lequel est réalisé un amincissement des deux substrats, du côté opposé à la couche de passivation (32).

## Patentansprüche

1. Verfahren zur Herstellung eines heterogenen Substrats, das dazu bestimmt ist, bei der Herstellung eines Halbleiters verwendet zu werden, das die folgenden Schritte umfasst:
(a) Liefern eines ersten Substrats (2) aus einem Material vom Typ II-VI oder III-V und eines zweiten Substrats (1), die im Wesentlichen eben sind und jeweils eine bestimmte Fläche aufweisen,
(b) Ausführung einer nicht durchgehenden Aussparung (10) durch Schleifen in dem zweiten Substrat (1), wobei die Fläche dieser Aussparung größer ist als die Fläche des ersten Substrats, derart, dass das erste Substrat in der Aussparung untergebracht werden kann,
(c) Aufbringen eines Klebematerials (15) in der Aussparung (10),
(d) Aufbringen des ersten Substrats (2) in der Aussparung (10) des zweiten Substrats und seine Befestigung in dem zweiten Substrat bei einer Temperatur unter 300 °C,
(e) Nivellieren des ersten und des zweiten Substrats, um ein heterogenes Substrat zu erhalten, das eine im Wesentlichen ebene Fläche (30) aufweist.

2. Verfahren nach Anspruch 1, wobei zwischen den Schritten (b) und (c) ein Polieren der Aussparung (10) ausgeführt wird.

3. Verfahren nach Anspruch 1 oder 2, wobei zwischen den Schritten (b) und (c) eine Texturierung (14) im Boden der Aussparung (10) ausgeführt wird.

4. Verfahren nach einem der Ansprüche 1 bis 3, wobei das zweite Substrat (1) aus einem Material ausgeführt ist, dessen Elastizitätsmodul größer als 50 GPa ist.

5. Verfahren nach einem der Ansprüche 1 bis 4, wobei der Unterschied zwischen dem thermischen Ausdehnungskoeffizienten des ersten Substrats und demjenigen des zweiten Substrats im Temperaturbereich von 0 bis 300 °C kleiner als 28% ist.

6. Verfahren nach einem der Ansprüche 1 bis 5, wobei der Schritt (e) durch Schleifen ausgeführt wird.

7. Verfahren nach einem der Ansprüche 1 bis 6, wobei nach dem Schritt (e) eine Passivierungsschicht (32) auf den zwei Substraten aufgebracht wird.

8. Verfahren nach Anspruch 7, wobei eine Verdünnung der zwei Substrate auf der der Passivierungsschicht (32) entgegengesetzten Seite ausgeführt wird.

## Claims

1. A method of obtaining a heterogeneous substrate for use in semiconductor fabrication, the method comprising the following steps:
a) providing a first substrate (2) of II-VI or III-V type material and a second substrate (1), the substrates being substantially plane and each presenting a determined area;
b) making a non-through recess (10) in the second substrate (1) by grinding, the area of this recess being greater than the area of the first substrate, such that the first substrate can be received in said recess;
c) depositing an adhesive material (15) in said recess (10);
d) depositing the first substrate (2) in the recess (10) in the second substrate and fastening it in the second substrate, at a temperature lower than 300°C; and
e) leveling the first and second substrates in order to obtain a heterogeneous substrate presenting a face (30) that is substantially plane.

2. A method according to claim 1, wherein a step of polishing the recess (10) is performed between the steps b) and c).

3. A method according to claim 1 or claim 2, wherein a texturing step (14) is performed in the bottom of the recess (10) between steps b) and c).

4. A method according to any one of claims 1 to 3, wherein the second substrate (1) is made of a material having a Young's modulus that is greater than 50 GPa.

5. A method according to any one of claims 1 to 4, wherein the difference between the coefficients of thermal expansion of the first and second substrates is less than 28% in the temperature range 0°C to 300°C.

6. A method according to any one of claims 1 to 5, wherein step e) is performed by grinding.

7. A method according to any one of claims 1 to 6, wherein a passivation layer (32) is deposited on the two substrates, after step e).

8. A method according to claim 7, wherein a step is performed of thinning the two substrates on the side opposite from the passivation layer (32).
